# EUROPEAN PATENT APPLICATION

(11) **EP 3 819 877 A2**
(43) Date of publication of application: **12.05.2021**
(21) Application number: 20202344.6
(22) Date of filing: 16.10.2020
(51) Int. Cl.: G07C 9/00

(54) **A SWITCHING ASSEMBLY AND USE THEREOF IN A HANDHELD WIRELESS DEVICE FOR REMOTELY ACTIVATING A REMOTE CONTROLLED SYSTEM**

(30) Priority: 16.10.2019 GB 201914930
(71) Applicant: Churchward, Mark, Ridlington, Norfolk NR28 9NZ (GB)
(72) Inventor: Churchward, Mark, Ridlington, Norfolk NR28 9NZ (GB)
(74) Representative: Sach, Greg Robert

(57) **Abstract**

A handheld wireless device for remotely activating a remote controlled system, the handheld wireless device comprising:
a casing holding an electrical energy store and circuitry including a transponder arranged to transmit a wireless signal in response to a request received from the remote controlled system;
the handheld wireless device further comprising a switching assembly comprising:
an electrical switch connected between the electrical energy store and the circuitry, the electrical switch operable by an applied magnetic field to switch the circuitry including transponder on and off; and
a mechanical actuator mounted to the casing, the mechanical actuator operable to move a magnet relative to the electrical switch to operate the electrical switch; the mechanical actuator and magnet being located outside the casing and the electrical switch being located inside the casing.

## Description

It has become increasingly common for manufactures to fit motor vehicles with keyless entry systems. A vehicle fitted with a keyless entry system will unlock and its engine start automatically when a handheld key fob paired with the vehicle is within sufficient proximity to the vehicle.

Keyless entry systems are convenient for the motorist but have proven to be vulnerable to relay hacking. In a relay hack a relay system is used to relay and record signals between the vehicle and a key fob. Through using a relay hack, a thief can open and start a vehicle without need of being in possession of the key fob or for the key fob to be proximate to the vehicle.

EP0984124 describes an electronic key for a motor vehicle that comprises a switch to prevent transmission of an identification signal from the key.

US2006/0238296 describes a key for a motorbike that comprises an off switch.

According to a first aspect of the invention there is provided a handheld wireless device for remotely activating a remote controlled system, the handheld wireless device comprising: a casing holding an electrical energy store and circuitry including a transponder arranged to transmit a wireless signal in response to a request received from the remote controlled system; the handheld wireless device further comprising a switching assembly comprising: an electrical switch connected between the electrical energy store and the circuitry, the electrical switch operable by an applied magnetic field to switch the circuitry including transponder on and off; and mechanical actuator mounted to the casing, the mechanical actuator operable by a user to move a magnet relative to the electrical switch to operate the electrical switch; the mechanical actuator and magnet being located outside the casing and the electrical switch being located inside the casing.

Using a magnet to control the electrical switch provides for the electrical switch to be controlled remotely through the casing avoiding the need to provide a hole in case of the device to fit the mechanical actuator. This simplifies retrofitting of the switching assembly and avoids compromising protection to ingress of dirt and water, etc provided by the case.

Although conceived for use with vehicle key fobs, the invention may be applied more broadly to provide a convenient means of retrofitting an on/off switch to other electronic devices.

The electrical switch may be mounted to the inside surface of the case.

It is preferred that the electrical switch, when switched to an off state, physically breaks the circuit between the battery and terminal e.g. moves an electrical contact or other conducting element of the circuit to introduce an air gap. This provides the advantage that it cannot be easily fused closed through application of a strong external radio power source as is possible with electronic switches. For this reason the electrical switch favourably comprises a reed switch. Alternatively other types of magnetically operable switch, e.g. those including a magnetic sensor such as, for example, a Hall Effect sensor, may be used instead.

The mechanical actuator may be bonded to the outside of the case. This provides a convenient means of installing the mechanical actuator, particularly if retrofitting the switching assembly to an existing handheld wireless transmitter device. Alternatively the mechanical actuator could be mounted to the inside of the casing and extend out of an aperture through the case.

The mechanical actuator may be bonded to the outside of the case with an adhesive. Alternatively, though less favourably, the mechanical actuator may be releasably bonded to the case for example using a hook and loop fastener. Where the device is a key fob, this allows temporary removal of the mechanical actuator, e.g. so that the key fob can be homed in a slot of the car, used as an alternative way to start the car in case the key fob battery fails.

The mechanical actuator may include a holder and an actuator element to which the magnet is mounted, the actuator element being movable relative to the holder to move the magnet relative to the electrical switch.

For example, the mechanical actuator may take the form of a flip switch. Where so, the actuator element may be arranged to pivot about a fulcrum provided by the holder. Alternatively the mechanical actuator may take the form of a slide switch, the actuator element being arranged to slide relative to the holder, e.g. about guides provided by the holder.

The mechanical actuator may be bonded to the outside of the case by way of a bond between the holder and the case. The switching assembly may comprise: a film of electrical insulator arranged between the electrical energy store (e.g. a battery) and a terminal of the circuitry; a first electrical conductor that provides an electrical connection between the electrical energy store and the electrical switch; and a second electrical conductor that provides electrical connection between the terminal of the circuitry and the electrical switch.

The film is preferably flexible which facilitates its interposition between the electrical energy store and the circuitry terminal such that power from the electrical energy store to run the circuitry can be controlled through the switching assembly. Such an arrangement allows for ease of retrofitting the switching assembly to an existing wireless device.

Favourably the first and second electrical conductors are bonded to and electrically isolated from one another by the film of electrical insulator.

With the film of electrical insulator interposed between the electrical energy store and the circuitry terminal, the first conductor may be supported on a first side of the film facing and in electrical contact with the electrical energy store, and the second conductor supported to the second side of the film facing and in electrical contact with the circuitry terminal.

The electrical conductors may comprise conductive metallic tape bonded to the film, though in a variant the conductors could be printed onto the film.

The film insulator may be comprised from a synthetic plastics material e.g. a polyester or polyimide such as Mylar® or Kapton® It is favourable that the total thickness of the film with conductors thereon is not more than 0.4mm, more favourably not more than 0.2mm. This ensures that the film is thin enough to be interposed between the electrical energy store and circuitry terminal, and also between the electrical energy store and the casing of the device to ease retrofitting of the switching assembly.

The electrical switch may be mounted to the film.

The switching assembly may additionally comprise: a further electrical switch; a motion sensor adapted to sense motion of the handheld device and to output a signal indicative thereof; and a controller arranged to receive the signal from the motion sensor; and to operate the further electrical switch to switch off the transponder in response to a determination that the wireless handheld device is motionless.

This provides an additional means to switch off the transponder that can function as an automatic backup in instances that the electrical switch is not manually operated by a user.

One or more, though favourably all (where present) of the further electrical switch, motion sensor, controller and clock are mounted on the film.

The switching assembly may include a clock that provides a timing signal to the controller in order that the controller switches off the further electrical switch once the device has been motionless for a predetermined period of time. The controller is favourably arranged to turn on the further electrical switch in response to determining that the wireless handheld device is moving. When the electrical switch is also on, this results in the circuitry and transponder being powered.

The controller is favourably powered by the electrical energy store. Therefore the film may carry a further electrical trace arranged to provide contact between a further terminal of the energy store and the switching circuitry such that the circuitry can be powered even when the electrical switch is off. Alternatively, the electrical switch may be arranged between the controller and the electrical energy store in order to switch off the controller when the electrical switch is turned off.

The hand held device may comprise a printed circuit board (PCB) that carries the circuitry and transponder. The flexible film may be connected between a terminal of the PCB and the electrical energy store. The switching assembly is thought to have inventive merit in of itself and thus according to a second aspect of the invention there is provided a switch assembly comprising: a film of electrical insulator, which when in use is, positioned between an electrical energy store and a terminal of circuitry to be powered by the battery;

a first electrical conductor connected to a mechanical switch assembly to provide electrical connection between the electrical energy store and the mechanical switch assembly; and a second electrical conductor connected to the mechanical switch assembly to provide electrical connection between the circuitry terminal and the mechanical switch assembly; the mechanical switch assembly being operable, when the switch assembly is in use, to switch between a first state in which the electrical energy store and terminal are in electrical connection via the first electrical conductor and second electrical conductor, and a second state in which the electrical energy store and electrical terminal are electrically isolated from one another.

The mechanical switch assembly favourably comprises an electrical switch operable by an applied magnetic field; to switch between the first state and the second state. Where so, the switch assembly may further comprise a mechanical actuator, which when in use is operable to move a magnet relative to the electrical switch to operate the electrical switch.

However, alternatively the electrical switch may comprise a mechanical electrical switch such as, for example, a conventional flip or push button switch which is exposed through the casing for access by a user. In such an arrangement the separate mechanical actuator can be omitted.

The first and second electrical conductors may be supported on and electrically isolated by the film of electrical insulator.

The film may be comprised of polyimide or polyester, e.g. Mylar(RTM).

The film may comprise a first side that faces a first direction and a second side that faces a second, opposite direction; and, the switch assembly comprises a sandwich structure comprising the film interposed between a first electrical conductive layer that provides the first electrical conductor and a second electrical conductive layer that provides the first electrical conductor, the first electrical conductive layer supported on the first side of the film and a second electrical conductive layer supported on the second side of the film.

The film may carry switching circuitry comprising a further electrical switch, which when the switching circuitry is installed for use, is connected between the energy store and the circuitry, a controller and a motion sensor; the controller arranged to receive signals from the motion sensor indicative of motion of the switching assembly and in response to operate the further electrical switch in order to switch off circuitry when it is detected that the switching assembly is motionless.

The controller is favourably arranged to turn on the switch in response to determining that the switching assembly is moving. When the electrical switch is also on, this results in the circuitry being powered.

The film may comprise an enlarged portion that carries electrical contact pads of the electrical traces that, when the film is installed for use, lies between a terminal of the electrical energy store and terminal of the circuitry. The film may comprise a further enlarged portion that is connected to the enlarged portion by a neck portion of the film. The further enlarged portion carrying a contact pad to contact a second terminal of electrical energy store, the third electrical trace providing an electrical path between the second terminal of electrical energy store and the switching circuitry.

The controller is favourably powered by the electrical energy store. Therefore the film may comprise a further electrical trace arranged to provide contact between a second terminal of the energy store and the switching circuitry such that the circuitry can be powered even when the electrical switch is off.

The thickness of the sandwich structure may not be more than 0.4mm, though more favourably not more than 0.2mm.

The film may be wider than the first connective layer and the second connective layer such that the film provides boarder portions adjacent the longitudinal edges of the first and second conductive layers.

The mechanical switch assembly may be operable to physically break a circuit connection between the first and second electrical conductors.

The invention may be described in terms of a method and therefore according to a further aspect of the invention there is provided a method of modifying an electronic device comprising a printed circuit board having a terminal that contacts a battery that powers the printed circuit board; the method comprising retrofitting to the electronic device a switch assembly, the switch assembly comprising: an mechanical switch assembly operable to electrically isolate the battery from the printed circuit board; and a composite connector comprising a film of electrical insulator carrying a first electrical conductor on a first side and the second electrical conductor on a second side, and the method comprises positioning the composite connector between the battery and a terminal of the printed circuit board terminal such that the first conductor faces and is in electrical connection with the battery and the second electrical conductor faces and is in electrical contact with the printed circuit board terminal, the composite connector acting to electrically isolate the battery from terminal.

The electronic device may be a handheld wireless device for remotely activating a remote controlled system, the handheld wireless device comprising: a transponder arranged to transmit a wireless signal in response to a request received from the remote controlled system; and

The method may comprise fitting a mechanical switch assembly operable to switch off the transponder so that it will not respond to a received request; wherein the mechanical switch assembly is fitted such that the mechanical switch assembly acts to electrically isolate the battery of the handheld wireless device from the printed circuit board carrying the transponder.

The first electrical conductor may provide an electrical connection between the battery and the mechanical switch assembly; and

a second electrical conductor that provides electrical connection between the printed circuit board terminal and the mechanical switch assembly.

The film of electrical insulator may carry the first electrical conductor on a first side and the second electrical conductor on a second side, and the method comprises positioning the film between the battery and the terminal such that the first conductor faces and is in electrical connection with the battery and the second electrical conductor faces and is in electrical contact with the PCB terminal.

The mechanical switch assembly may comprise an electrical switch connected between the electrical energy store and the circuitry, the electrical switch operable by an applied magnetic field to switch the circuitry on and off; and a mechanical actuator mounted to a casing of the device and operable to move a magnet relative to the electrical switch to operate the electrical switch; the mechanical actuator and magnet being located outside the casing and the electrical switch being located inside the casing.

The method may include mounting the mechanical actuator onto an outside surface of case.

The invention will now be described by way of example with reference to the following figures in which:
Figures 1A and 1B are side view schematics of a hand held device for activating a remote controlled system shown in off and on states;
Figure 1C is a perspective view of the mechanical actuator of Figures 1A and 1B;
Figures 2A and 2B are side view schematics of a hand held device with a variant switch assembly shown in respective off and on states;
Figure 2C is a perspective view of the mechanical actuator of Figures 2A and 2B;
Figures 3A, 3B and 3C are plan, side and end on views of an electrically conductive composite film forming part of a switching assembly;
Figures 4A and 4B are plan views of opposing sides of a variant electrically conductive composite film carrying switching circuitry; and
Figure 5 is a schematic circuit diagram of a circuit formed when the electrically conductive composite film of Figures 4 is installed in a hand held device of Figure 1 or 2.

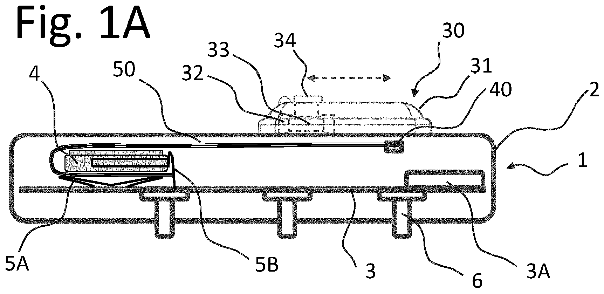

Figures 1A-1C illustrate a hand held device 1 for activating a remote controlled system such as a remote controlled lock (and/or remote controlled switch). In an example embodiment the hand held device 1 is a key fob for a motor vehicle forming part of the motor vehicle's keyless entry system.

The device 1 comprises a case 2. The case 2 houses a printed circuit board (PCB) 3 that carries circuitry that includes a transponder 3A' (shown notionally) adapted to receive a wireless signal from the remote controlled system and in response transmits a signal which when received by the remote controlled system causes said system to activate (e.g. unlock remote controlled lock, and/or open or close remote controlled switch).

The circuitry is powered by a battery 4 (or other electrical energy store), typically a button cell, via two electrical contacts 5A 5B of the PCB 3.

The device 1 optionally also includes a number of push button switches 6 operable by a user to cause the circuitry on the PCB 3 to carry out a number of pre-defined functions.

The hand held device includes a flexible switching assembly comprising a mechanical slide switch assembly 30 mounted on the outside of the case 2, and a reed switch 40 which is mounted on a composite film connector 50 housed within the case 2.

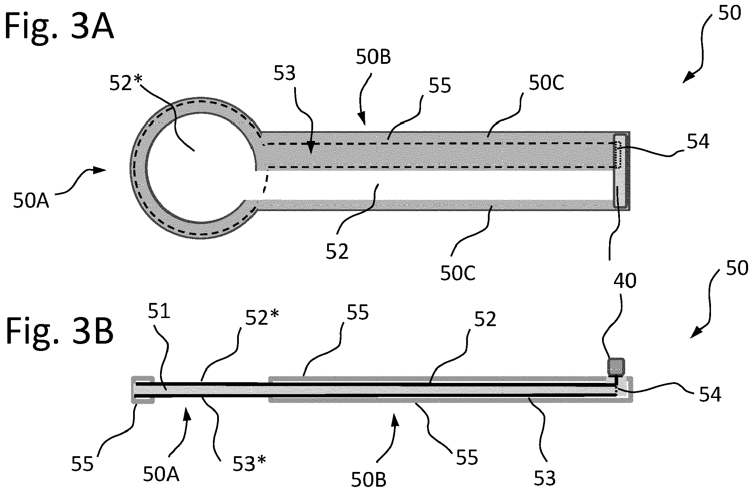

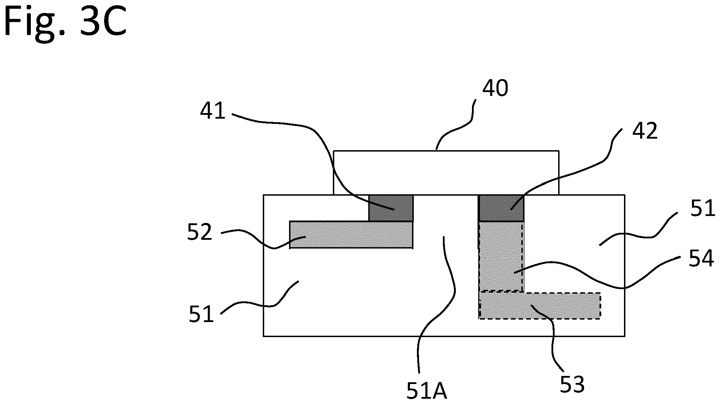

With reference to Figures 3A, 3B and 3C, the composite film connector 50 comprises a film 51 e.g. of polyester such as Myla(TM) that carries on both sides, and thus interposed between, electrically conductive layers (e.g. of metal) patterned to define first and second electrically conductive traces 52, 53. The two conductive traces 52, 53 contact respective terminals 41 42 of the reed switch 40 which is mounted on the first side of the film 51.

The first electrically conductive trace 52 lies on a first side (that facing towards the reader in Fig 3A) of the film 51. The second electrically conductive trace 53 lies on a second side of the film 51, its outline indicated by the dashed line on Fig 3A and Fig 3C. A via 54 through the film 51 provides electrical connection between the second electrical trace 52 and the reed switch 40 terminal. The first trace 52 and second portion 53B of the second trace are separated by a portion 51A of the film 51.

The composite film connector 50 comprises an enlarged portion 50A and a relatively narrow elongate portion or tail 50B. On the enlarged portion 50A, which is intended to be interposed directly between the battery 41 and PCB terminal 5B, the first and second traces are enlarged providing contact pads 52* 53* to allow for good electrical contact to be made between respectively the first trace 52 with the terminal of the battery 4, and the second trace 53 with the terminal 5A of PCB 3.

The composite film connector 50 comprises an outer electrical insulation layer 55, e.g. of epoxy resin, that covers both sides of the film 51 including and electrically conductive layers other than in the regions of the contact pads 52* 53* and reed switch terminals 41 42. The insulating layer 55 functions to protect the conductive layers and prevent short circuiting.

The thickness of the film with traces is favourably sufficiently small to allow it to be interposed between the circuitry terminal and battery without difficulty. A thickness of around 0.2mm or less is preferred though up to 0.4mm will still be effective.

The film 51 is broader than the traces 52, 53 to provide boarder portions 50C adjacent the traces 52 53 about their length.

The reed switch 40 is mounted on the elongate portion 50B, in this example about the terminus of the elongate portion 50B. This arrangement allows the reed switch 40 to be located remote from the battery 4 adjacent and/or against an inner wall of casing 2 in relatively close proximity to the mechanical slide switch assembly 30.

With the composite film connector 50 interposed between the battery 4 and connector 5A, direct electrical connection between the two is interrupted. Instead electrical connection between the two is made through a bypass circuit provided by the first conductive trace 52, second conductive trace 53 and reed switch 40 that connects between the first and second traces 52, 53; the reed switch 40 providing means to switchably open or close the bypass circuit to control whether the circuitry on the PCB 3 including transponder 3 is powered by the battery 4.

The mechanical slide switch assembly 30 comprises a holder 31 and an actuator member 32 arranged to slide a magnet 33, between two positions within the holder 31.

The holder 31 is arranged on an outside face of the case 2. The holder 31 includes a slot 31A and guide member(s) (not shown). The holder 31 may be bonded to the outer face of the case 2 using, for example, an adhesive, a hook and loop fastener or other means such as plastic welding.

These methods of mounting are favoured over those using a fastener that passes through the case 2, e.g. a screw or rivet as the latter require one or more holes to be formed within the case 2 which may compromise the degree of ingress protection to water and/or dirt provided by the case 2.

The actuator member 32 comprises a button 34 that extends through the slot 31A of the holder 30 allowing a user to slide the actuator member 32 and the magnet 33, which lies within the holder 31, about the guide member(s), between the two positions within the holder 31.

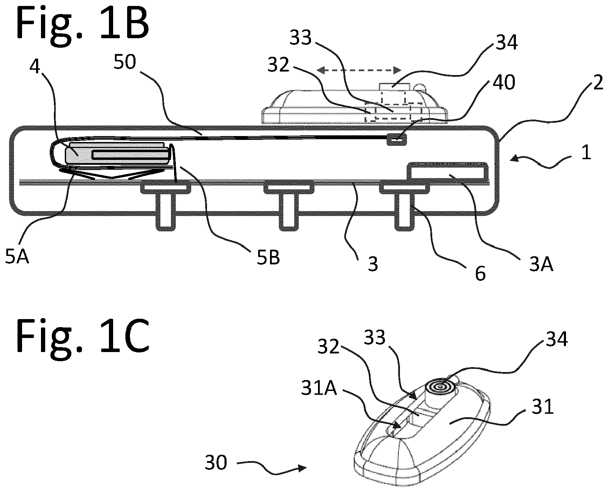

The reed switch 40 and mechanical slide switch assembly 37 are positioned so that when the magnetic actuator member 33 is in a first position, illustrated in Fig 1A, the magnet 33 is relatively remote from the reed switch 40 such that the reed switch 40 is off, and that the action of moving the actuator member 32 to the second position (Fig 1B) brings the magnet 33 into close enough proximity to the reed switch 40 as to turn it on.

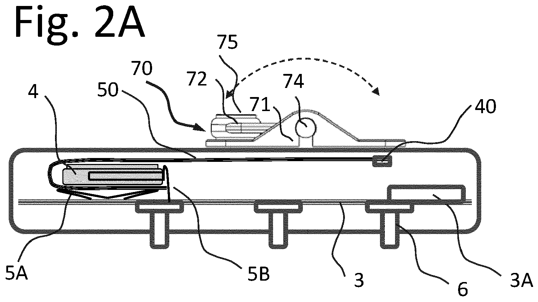

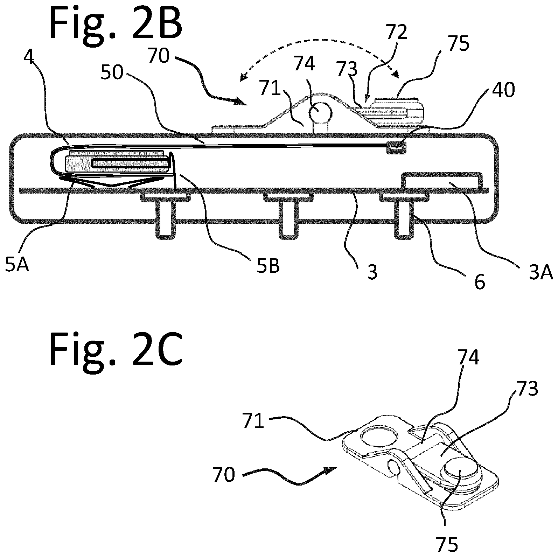

Figures 2A and 2B illustrate the hand held device 1 with a variant switching assembly that includes a mechanical flip switch assembly 70 in place of the slide switch 30 of Figures 1A- 1C.

The mechanical flip switch assembly 70 comprises a holder 71, and an actuator 72 that includes an arm 73 and pin 74 about which the actuator 72 is rotatably mounted to the holder 71. The arm 73 carries a permanent magnet 75 and is arranged to pivot about pin 74 against a fulcrum provided by the holder 71 so that the magnet 75 is moveable between a first position shown in Figure 2A and second position shown in Fig 2B to switch the reed switch 40 off or on.

The holder 71 may be mounted on an outside face of the case 2 in the same way as the holder 31 of the embodiment of Fig 1.

In the embodiments of Figs 1 and 2 the reed switch is off when the magnet is remote from it and on when the magnet 75 is close to it. It will be appreciated that this arrangement could be reversed.

Further variations to Figures 1 and 2 are possible that use mechanical switch mechanisms other than slide or flip switches.

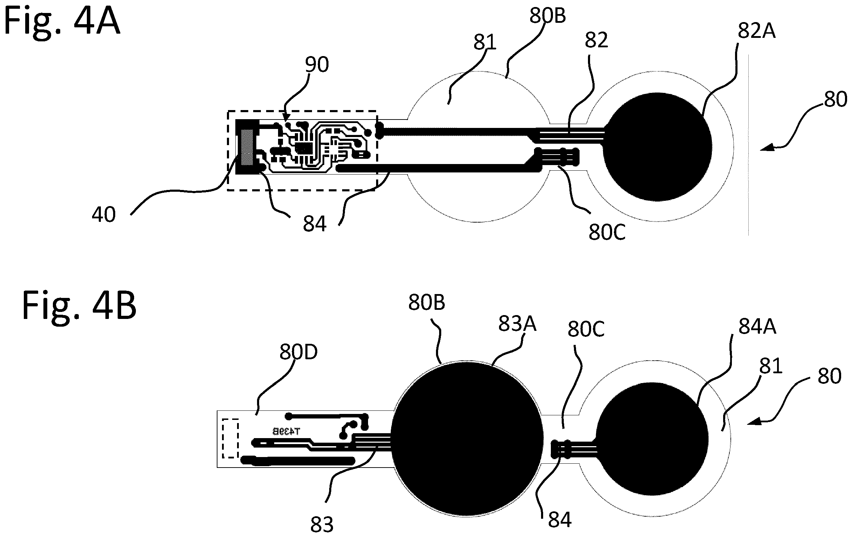

With reference to Figures 4A and 4B there is shown an alternative composite film connector 80 that carries switching circuitry 90 to provide additional functionality to the switch assembly.

The composite film connector 80 comprises a flexible film 81 of Mylar(TM) or other suitable synthetic polymer that carries on both sides, and thus interposed between, electrically conductive layers (e.g. of metal) patterned to provide first, second and third electrically conductive traces 82, 83, 84. The patterning of the electrical conductive layer also provides connective traces for the switching circuitry 90.

The composite film connector 80 comprises a first and second enlarged portions 80A 80B connected by a relatively narrow neck portion 80C. A elongate 'tail' portion 80D extends from the second enlarged portion 80B.

With reference Fig 4A, the first conductive trace 82 lying on a first side of the film, comprises a contact pad 82A on a first side of the first enlarged portion 80A and extends to a first terminal of the switching circuitry 90.

A second conductive trace 83 comprises a contact pad 83A on a second side of the second enlarged portion 80A (see Fig 4B). The trace 83 extends to a second terminal of the switching circuitry 90.

20 A third conductive trace 84 comprises a contact pad 84A on a second side of the first enlarged portion 80A (opposite contact pad 82A of the first trace 82) and extends to an input of the reed switch 40 though the switching circuitry 90.

The second and third conductive traces 83, 84 comprise portions that extend on both sides of the film 81 in order to bypass the other traces and/or the circuitry 90. Connection between said portions is made by connective vias through the film 81.

When installed, the first enlarged portion 80A is interposed between a first terminal of the battery 4 and the PCB terminal 5A such that the first trace 82 provides an electrical connection between the PCB terminal 5A and the first terminal of the circuitry 90, and the second trace 84 provide an electrical connection between the first terminal of the battery 4 and a terminal of the reed switch 40.

The second side of the second enlarged portion 80B is in contact with a second terminal (opposite polarity to first terminal) of the battery 4 such that that the third trace 85 provides an electrical connection between the second terminal of the battery 4 and the second terminal of the switching circuitry 90.

To provide this arrangement the film 51 is bent about the neck portion 80C so that the two enlarged portions lie against opposing faces of the (button cell) battery 4 with the neck portion 80 extending around the side of the battery 4.

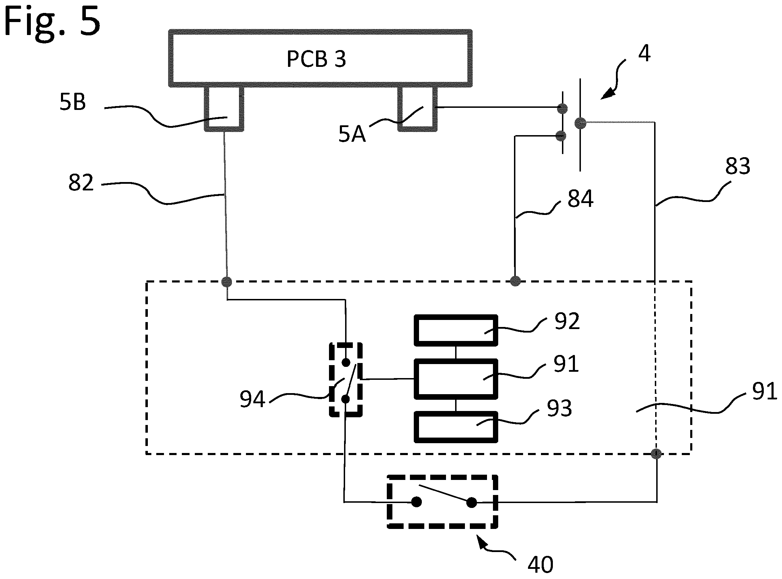

Figure 5 is a schematic of the circuit formed once the film connector 80 is installed as described above, together with functional components of the circuitry 90.

The circuitry 90 includes a controller 91, a clock 92, a motion sensor 93 and a electronic switch 94.

The circuitry 90 is powered by its connection to the two battery terminals provided by the second and third traces 83, 84.

The electronic switch 94 is arranged in series with the reed switch 40 such that the circuitry of the PCB 3 will only be powered when both the reed switch 40 and electronic switch 94 are closed.

The controller 91 is arranged to receive signals from the motion sensor 93 indicative of motion of the device 1, and clock signals from the clock 92. The controller 91 is programmed to use the received signal to switch the electronic switch 94 'on' when motion of the device 1 is detected and to switch the electronic switch 94 'off' following a period of time in which the device 1 is determined to be motionless.

This arrangement provides a means to switch the PCB circuitry off automatically. It can function as a failsafe mechanism in instances that the reed switch 40 is not turned off manually by a user operating the mechanical switch assembly 30, 70.

The motion sensor 93 may comprise one or more accelerometers. The electronic switch 94 may be comprised of one or more transistors.

In a variant design, power to the switching circuitry 90 may be arranged through the reed switch 40 such that the switching circuitry is only functioning when the reed switch 40 is on. This arrangement may prolong the life of the battery 4.

In a variant to any of the designs of Figures 1 - 5 the reed switch 40 may be replaced with a Hall Effect switch or other magnetically actuated switch. Notwithstanding, a reed switch is preferred to a Hall Effect switch as it physically opens the circuits when switching to an off state.

In a further, though less favourable, variant design the composite film connector could be used to connect to an electrical switch other than a magnetically operable one, e.g. a simple slide or push button switch which extends through the casing in order to be operable by a user.

## Claims

1. A handheld wireless device for remotely activating a remote controlled system, the handheld wireless device comprising:
a casing holding an electrical energy store and circuitry including a transponder arranged to transmit a wireless signal in response to a request received from the remote controlled system;
the handheld wireless device further comprising a switching assembly comprising: an electrical switch connected between the electrical energy store and the circuitry, the electrical switch operable by an applied magnetic field to switch the circuitry including transponder on and off; and
a mechanical actuator mounted to the casing, the mechanical actuator operable to move a magnet relative to the electrical switch to operate the electrical switch; the mechanical actuator and magnet being located outside the casing and the electrical switch being located inside the casing.

2. A handheld wireless transmitter device according to claim 1 wherein the electrical switch comprises a reed switch and the mechanical actuator is bonded to the outside of the case wherein the mechanical actuator comprises a holder, and an actuator element to which the magnet is mounted; the actuator element being movable relative to the holder to move the magnet relative to the electrical switch

3. A handheld wireless transmitter device according to any previous claim wherein the switching assembly comprises:
a film of electrical insulator arranged between the electrical energy store and a terminal of the circuitry;
a first electrical conductor that provides an electrical connection between the electrical energy store and the electrical switch; and a second electrical conductor that provides electrical connection between the terminal of the circuitry and the electrical switch.

4. A handheld wireless device according to claim 3 wherein the first and second electrical conductors are electrically conductive layers supported on and electrically isolated from one another by the film of electrical insulator and the electrical switch is mounted on the film.

5. A handheld wireless device according to any previous claim wherein the switching assembly comprises:
a further electrical switch;
a motion sensor adapted to sense motion of the handheld device and to output a signal indicative thereof; and
a controller arranged to receive the signal from the motion sensor; and to operate the further electrical switch to switch off the transponder in response to a determination that the wireless handheld device has been motionless for a predetermined period of time.

6. A handheld wireless device according to claims 3 and 5 wherein the motion sensor and controller are mounted on the film and the controller is powered by the electrical energy store.

7. A handheld wireless device according to any previous claim wherein the remote controlled system is a remote controlled lock and/or remote controlled switch of a motor vehicle.

8. A switch assembly comprising:
a film of electrical insulator, which when in use is, positioned between an electrical energy store and a terminal of circuitry to be powered by the battery;
a first electrical conductor connected to a mechanical switch assembly to provide electrical connection between the electrical energy store and the mechanical switch assembly; and
a second electrical conductor connected to the mechanical switch assembly to provide electrical connection between the circuitry terminal and the mechanical switch assembly;
the mechanical switch assembly being operable, when the switch assembly is in use, to switch between a first state in which the electrical energy store and terminal are in electrical connection via the first electrical conductor and second electrical 10 conductor, and a second state in which the electrical energy store and electrical terminal are electrically isolated from one another.

9. A switch assembly according to claim 8 wherein the mechanical switch assembly comprises:
an electrical switch operable by an applied magnetic field; to switch between the first state and second state; and
a mechanical actuator operable to move a magnet relative to the electrical switch to operate the electrical switch.

10. A switch assembly according to any claim 8-9 wherein the first and second electrical conductors are supported on and electrically isolated by the film of electrical insulator.

11. A switch assembly according to any claim 8-10 wherein the film comprises a first side that faces a first direction and a second side that faces a second, opposite direction; and, the switch assembly comprises a sandwich structure comprising the film interposed between a first electrical conductive layer that provides the first electrical conductor and a second electrical conductive layer that provides the first electrical conductor, the first electrical conductive layer supported on the first side of the film and a second electrical conductive layer supported on the second side of the film.

12. A switch assembly according to claim 11 wherein the film is wider than the first connective layer and the second connective layer such that the film provides boarder portions adjacent the longitudinal edges of the first and second conductive layers and longer than the connector to provide a tab at a longitudinal end of the first and second connectors.

13. A method of modifying an electronic device comprising a printed circuit board having a terminal that contacts a battery that powers the printed circuit board; the method comprising retrofitting to the electronic device a switch assembly comprising an mechanical switch assembly operable to electrically isolate the battery from the printed circuit board wherein the switching assembly further comprises a composite connector comprising a film of electrical insulator carrying a first electrical conductor on a first side and the second electrical conductor on a second side, and the method comprises positioning the composite connector 20 between the battery and a terminal of the printed circuit board terminal such that the first conductor faces and is in electrical connection with the battery and the second electrical conductor faces and is in electrical contact with the printed circuit board terminal, the composite connector acting to electrically isolate the battery from terminal.

14. A method of modifying a handheld wireless device for remotely activating a remote controlled system, the handheld wireless device comprising:
a transponder arranged to transmit a wireless signal in response to a request received from the remote controlled system; and
the method comprising fitting an mechanical switch assembly operable to switch off the transponder so that it will not respond to a received request; wherein the mechanical switch assembly is fitted such that the mechanical switch assembly acts to electrically isolate a battery of the handheld wireless device from a printed circuit board carrying the transponder.

15. A method according to claim 14 comprising:
positioning a film of electrical insulator between the battery and a electrical terminal of the printed circuit board;
a first electrical conductor that provides an electrical connection between the battery and the switch; and a second electrical conductor that provides electrical connection between the printed circuit board terminal and the switch.
